(19) Europäisches Patentamt
European Patent Office
Office européen des brevets

(11) **EP 4 495 692 A1**

(12) **EUROPEAN PATENT APPLICATION**

(43) Date of publication:
**22.01.2025 Bulletin 2025/04**

(21) Application number: **23186771.4**

(22) Date of filing: **20.07.2023**

(51) International Patent Classification (IPC):
*G03F 7/20* (2006.01)

(52) Cooperative Patent Classification (CPC):
**G03F 7/70725; G03F 7/70058; G03F 7/70141**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **BOGAART, Erik, Willem**
**5500 AH Veldhoven (NL)**

(74) Representative: **ASML Netherlands B.V.**
**Corporate Intellectual Property**
**P.O. Box 324**
**5500 AH Veldhoven (NL)**

(54) **OPTICAL ARRANGEMENT FOR USE IN AN EXPOSURE APPARATUS WITH A MASK TABLE ASSEMBLY AND A PART OF AN OPTICAL SCANNING ASSEMBLY MOVABLE IN OPPOSITE DIRECTIONS AND CORRESPONDING METHOD OF EXPOSING A CIRCUIT PATTERN ON A SUBSTRATE**

(57)    Disclosed is an optical arrangement for use in an exposure apparatus, comprising: an object table assembly configured to hold and move an object in a plane of the object; and an optical scanning assembly configured to receive a radiation beam, direct the radiation beam towards the object so as to illuminate at least an area of the object in the plane of the object, and subsequently collect at least part of the radiation beam coming from the object; wherein the object table assembly and at least a part of the optical scanning assembly are operable to move concurrently while the object is being illuminated by the radiation beam such that the optical scanning assembly moves the radiation beam in a direction substantially anti-parallel to a direction of movement of the object table assembly thereby scanning the radiation beam over at least a portion of said object.

Fig. 3

EP 4 495 692 A1

**Description**

FIELD OF THE INVENTION

The present invention relates to an optical arrangement for use in an exposure apparatus, and a method for improving throughput of an exposure apparatus using such an optical arrangement.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of a die, one die, or several dies) on a substrate (e.g., a silicon wafer) that is provided on a substrate support (or substrate table). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

As semiconductor manufacturing processes continue to advance, the dimensions of circuit elements have continually been reduced while the substrate throughput is increased. This provides more demanding constrains to lithographic systems. One way to increase wafer throughput in a lithographic apparatus may be to reduce exposure time per field. This may be achieved for example by increasing the moving or scanning speed of the patterning device support (e.g., mask support) and the substrate support. A typical lithographic exposure apparatus comprises a projection system that is configured to provide an optical demagnification ratio of, for example, 4:1. This means for this example that a patterning device support, which is arranged to support the patterning device, moves at a speed four times higher than the speed of the substrate support. The accelerations and/or decelerations of the patterning device support that are required to support the increased moving or scanning speed have become rather challenging.

In order to achieve a higher substrate throughput of lithographic systems, without the need of excessive high accelerations and velocities of the patterning device support and substrate support, substrate exposures are performed at non-constant velocity, as is disclosed, for example, in US6788391B2 and US7016013B2. This means that not only the target portion (field) is exposed when the substrate support moves with constant velocity, the target portion is also exposed during the acceleration and the deceleration of the substrate support (before and after the exposure period at constant velocity of the substrate support, respectively). To provide a sufficient dose at the target portion, the time interval between successive light pulses (from an excimer laser, for example) is inversely proportional to the velocity of the substrate support. This means that the laser pulse rate is adapted to the substrate support velocity, even during acceleration and deceleration of the substrate support. Controlling the exposure dose by varying the laser output (or the output of the radiation system) in response to the velocity of the substrate support may result in instabilities or undesired fluctuations at the laser (or radiation system). As a result, the exposure dose at the substrate may not be at the required level for at least a portion of the target portion, which may result in non-yielding dies.

As said in semiconductor manufacturing, it is always desirable to continuously increase wafer (or patterning) throughput so as to improve productivity. Therefore, it is the object of the present disclosure to further increase throughput of existing lithographic apparatuses while at the same time addressing the aforementioned problems.

SUMMARY OF THE INVENTION

The invention in a first aspect provides an optical arrangement for use in an exposure apparatus, comprising: an object table assembly configured to hold and move an object in a plane of the object; and an optical scanning assembly configured to receive a radiation beam, direct the radiation beam towards the object so as to illuminate at least an area of the object in the plane of the object, and subsequently collect at least part of the radiation beam coming from the object; wherein the object table assembly and at least a part of the optical scanning assembly are operable to move concurrently while the object is being illuminated by the radiation beam such that the optical scanning assembly moves the radiation beam in a direction substantially anti-parallel to a direction of movement of the object table assembly thereby scanning the radiation beam over at least a portion of said object.

The invention in a second aspect provides a lithographic apparatus comprising an optical arrangement according to the first aspect.

The invention in a third aspect provides a method of exposing a circuit pattern on at least one target portion on a substrate, comprising: illuminating a patterning device by a radiation beam; moving the patterning device in a first direction in a plane of the patterning device while the patterning device is being illuminated by the radiation beam; and moving the radiation beam with respect to the patterning device in a second direction opposite to the first direction; wherein the patterning device and the radiation beam are moved concurrently while the patterning device is being illuminated by the radiation beam; exposing at least one target portion on the substrate using at least part of the radiation beam coming from the patterning device.

Also disclosed is a computer program and lithographic apparatus being operable to perform the method of the first aspect or second aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 depicts schematically an optical arrangement for use in an exposure apparatus (e.g., the lithographic apparatus of Figure 1) in accordance with an embodiment;
Figures 4A-4C depict schematically an embodiment optical arrangement 400 configured for use in a lithographic apparatus of transmissive type (e.g., a DUV scanner) at three different time instances during exposures; and
Figures 5A and 5B depict schematically a different embodiment optical arrangement configured for use in a lithographic apparatus of reflective type at two different time instances during exposures.

DETAILED DESCRIPTION OF EMBODIMENTS

Before describing embodiments of the invention in detail, it is instructive to present an example environment in which embodiments of the present invention may be implemented.

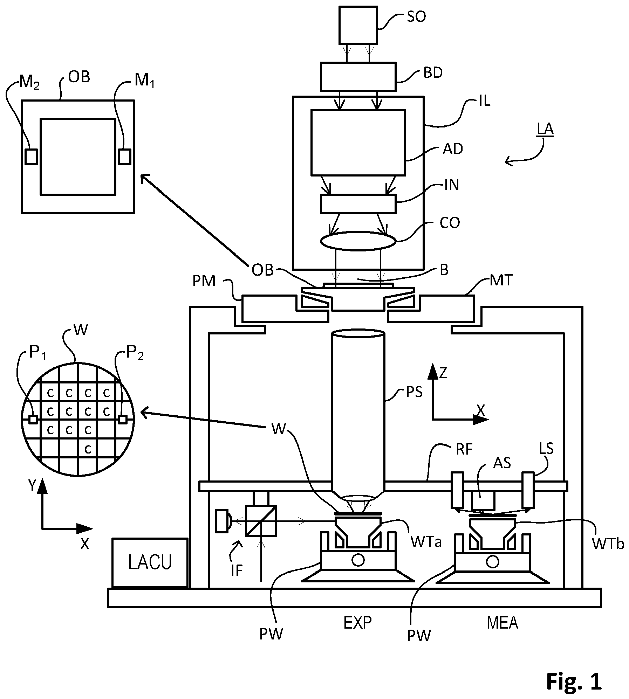

Figure 1 schematically depicts a lithographic apparatus LA. The apparatus includes an illumination system (illuminator) IL configured to condition a radiation beam RB (e.g., UV radiation or DUV radiation), a patterning device support or support structure (e.g., a mask table) MT constructed to support an object OB, which in this particular example is a patterning device (e.g., a mask) and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam RB by patterning device OB onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam RB, an integrator IN and a condenser CO. The illuminator may be used to condition the radiation beam RB, to have a desired uniformity and intensity distribution in its cross section.

The radiation beam RB is incident on the patterning device OB, which is held on the patterning device support MT, and is patterned by the patterning device. Having traversed the patterning device (e.g., mask) OB, the radiation beam RB passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions (fields) C in the path of the radiation beam RB. Similarly, the first positioner PM and another position sensor (which is not explicitly depicted in Figure 1) can be used to accurately position the patterning device (e.g., mask) OB with respect to the path of the radiation beam RB, e.g., after mechanical retrieval from a mask library, or during a scan.

Patterning device (e.g., mask) OB and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) OB, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam RB is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

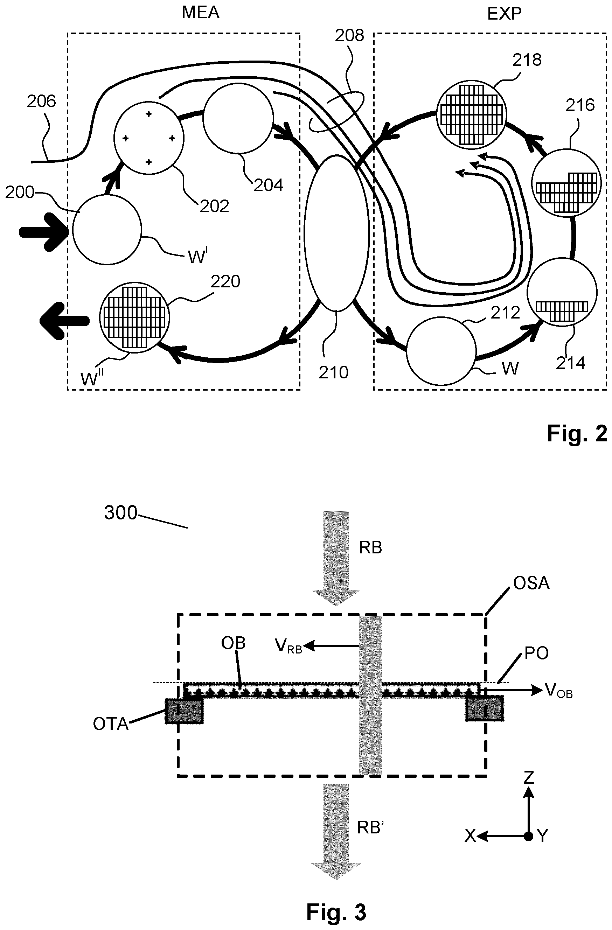

Figure 2 illustrates the steps to expose target portions (e.g., fields or dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the flow of Figure 2, on the measurement side, the wafer alignment data measured at step 202 and the wafer height/leveling data measured at step 204 are both measured with respect to a reference arrangement or fiducial. For example, the fiducial may comprise a fiducial sensor on a wafer stage or chuck (more generally a substrate support) and a plurality of reference structures (e.g., a set of marks), comprising respectively one or more reference structures or marks on the substrate support and one or more reference structures or marks on the reticle and/or reticle stage.

On the measurement side, an alignment sensor and/or leveling sensor illuminates the one or more substrate support marks on the fiducial surface during alignment and leveling (typically both will be performed; however the concepts disclosed herein are individually applicable to measurement-to-exposure matching in one or both dimensions parallel to the substrate plane and/or the direction perpendicular to the substrate plane). As a result, the aligned wafer position in the wafer plane is described with respect to the fiducial by the wafer alignment data (measurements of alignment structures or marks on the wafer) and/or the wafer position in the direction perpendicular to the wafer plane is described with respect to the fiducial by the leveling data. Typically more than one mark is measured on the fiducial, enabling the shape, and therefore any drift in this shape over time, of the fiducial surface to be characterized or modeled. This may be done using alignment modeling techniques, e.g., to measure and model an aligned position deviation (APD) with respect to nominal or expected positions of each mark assuming a perfectly flat surface.

On the exposure side, the reticle alignment step of step 212 aligns the reticle with respect to the fiducial. This may be achieved by using the fiducial sensor on the fiducial to measure illumination (e.g., from the exposure source) via one or more reference structures or marks on the reticle and/or reticle stage. In addition to reticle stage positioning, other corrections may be performed at the expose side, e.g., lens corrections based on lens aberration measurements (wavefront measurements) which may also be performed by the fiducial sensor.

In performing these measurement steps 202, 204, 212, each with respect to the fiducial, the position of the reticle with respect to the wafer can be determined.

The exposure side metrology uses the measurement side metrology as a baseline and assumes that the measurements are correct. For example, the exposure side will correct exposure side measurements and/or models (e.g., for reticle shape and/or lens aberrations) based on the fiducial surface shape measured on the measurement side.

An initial calibration step, sometimes referred to as measurement-to-exposure matching, is typically performed during set-up of the lithographic apparatus. Simplistically, this matching is done using "stage alignment" measurements in measurement side, and "reticle alignment" measurements on the exposure side. This matching calibrates any difference between the exposure side fiducial metrology to the measurement side fiducial metrology due to the different methods used at each side. During production, the fiducial is subject to temporal drift. As such, the measurement side metrology is performed routinely on the fiducial to characterize/model this drift. In this manner, any changes to the fiducial over time will be taken into account at the exposure side. However, monitoring of this drift works under the assumption that the measured fiducial will be seen the same on the measurement side and exposure side, such that the same fiducial temporal drift is captured.

However, because the measurement methods and measured structures on each side differ this is not always the case, and differences in the measured drift will be detected on each side in practice. In particular, because only the measurement side measures (marks on) the surface of the fiducial, rather than using cameras/detectors within the fiducial, anything which degrades this surface and/or the marks thereon will be detected only on the measurement side. Such degradation includes degradation of the marks themselves and/or of the fiducial coating.

Once the measurement side metrology is modeled, the modeled data will comprise a main fiducial description component describing the fiducial surface shape and an additional nuisance component resulting from the fiducial degradation. On the expose side, this additional nuisance component will not be measured, only the main component. The expose side control will therefore incorrectly assume that this additional nuisance component has resulted from expose side error (e.g., reticle, lens and/or reticle stage error) and determine erroneous corrections for this (e.g., via reticle, lens and/or reticle stage control/actuation). These erroneous "corrections" will be directly responsible for imaging errors in the final product.

In semiconductor manufacturing, it is always desirable to continuously increase wafer (or patterning) throughput so as to improve productivity. One way to increase wafer throughput in a lithographic apparatus may be to reduce exposure time per field (or target portion). This may be achieved for example by increasing the moving or scanning speed of the patterning device support (e.g., mask support) and the substrate table. Referring temporally back to Figure 1, the lithographic apparatus LA of the transmissive type comprises a projection system (e.g., a catadioptric projection lens system) PS configured to project a pattern imparted to the radiation beam B by the patterning device OB onto a target portion C of the substrate W. The projection system PS is configured to provide an optical demagnification ratio of, e.g., 4:1. This means that the patterning device support MT moves at a speed four times higher than the substrate table WTa. The accelerations and/or decelerations of the patterning device support MT that are required to support the increased moving or scanning speed have become rather challenging. First, it is very difficult to keep on increasing the moving speed of the patterning device support MT and the substrate table WTa given that their present moving speeds and accelerations are already high. Secondly, large accelerations and/or decelerations of the patterning device support MT unavoidably introduce disturbances of various kinds to the system, which may result in deteriorated performance. Furthermore, increasing the moving speed of the patterning device support MT requires the system load to be increased accordingly.

An alternative way to increase wafer throughput may be to configure the positioners (e.g., the first positioner PM and the second positioner PW of Figure 1) for the patterning device support (e.g., mask support) and the substrate table (e.g., wafer table) in such a way that exposure of the substrate takes place when both of the patterning device support and the substrate table move or scan at a non-constant velocity. This can be achieved by applying sinusoidal setpoints to the positioners to ensure a continuous variation in the velocity. However, such a method is complex and error sensitive.

Therefore, it is the object of the present disclosure to provide a method and an apparatus that are capable of improving the wafer throughput of a lithographic apparatus while at the same time addressing the aforementioned problems.

According to an aspect of the present disclosure and with reference to Figure 3, there is provided an optical arrangement 300 for use in an exposure apparatus, for example the lithographic apparatus LA as illustrated in Figure 1, comprising: an object table assembly OTA configured to hold and move an object OB in a plane of the object PO; and an optical scanning assembly OSA configured to receive an input radiation beam RB, direct the input radiation beam RB towards the object OB so as to illuminate at least an area of the object OB at the plane of the object (object plane) PO, and subsequently collect at least part of the radiation beam RB' coming from the object OB (e.g., a portion of the radiation beam RB' having transmitted through the object OB); wherein the object table assembly OTA and at least a part of the optical scanning assembly OSA are operable to move concurrently while the object OB is being illuminated by the input radiation beam RB such that the optical scanning assembly OSA moves the input radiation beam RB in a direction (e.g., the direction of velocity $V_{RB}$ shown in Figure 3) substantially anti-parallel or opposite to a direction (e.g., the direction of velocity $V_{OB}$ shown in Figure 3) of movement of the object table assembly OTA thereby scanning the input radiation beam RB over at least a portion of said object OB.

As shown in Figure 3, the object OB moves at a first velocity $V_{OB}$ in a first move direction (e.g., to the right) along the X-axis and the input radiation beam RB moves at a second velocity $V_{RB}$ in a second move direction opposite to the first move direction. As such, the effective velocity $V_{eff}$ of the object OB relative to the input radiation beam RB is the sum of the actual velocities of the object $V_{OB}$ and the input radiation beam $V_{RB}$, which can be expressed as:

$$\left|V_{eff}\right| = \left|V_{OB}\right| + \left|V_{RB}\right|. \tag{1}$$

The velocity $V_{OB}$ of the object OB and the velocity $V_{RB}$ of the input radiation beam RB can be expressed in terms of the effective velocity $V_{eff}$ as:

$$\left|V_{OB}\right| = x \bullet \left|V_{eff}\right|, \tag{2}$$

$$\left|V_{RB}\right| = (1-x) \bullet \left|V_{eff}\right|, (0 < x < 1). \tag{3}$$

This enables an increased relative velocity $V_{eff}$ between the object OB and the input radiation beam RB, while the velocity $V_{OB}$ of the object OB is kept relatively low. As such it takes less time for the input radiation beam RB to move across the object OB. If such an optical arrangement were used in a lithographic apparatus (e.g., as shown in Figure 1), the exposure time per field would therefore be reduced and accordingly the wafer throughput would be increased. In such a case, the velocity of the substrate support (e.g., WTa in Figure 1) will be synchronized with the effective velocity $V_{eff}$ of the object OB during exposures. For example, with a projection system PS having an optical demagnification ratio of, e.g., 4:1, the velocity $V_{WTa}$ of the substrate support WTa will be $V_{WTa} = 0.25 \times V_{eff}$. It would be obvious to the skilled person that for projection lens systems with a certain demagnification DM, the velocity of the substrate support WTa would be $V_{WTa} = V_{eff}/DM$. The demagnification DM may be, for example, 2x, 3x, 4x, 6x, or 8x, or any value within this range.

It will be appreciated by the skilled person that the velocities $V_{OB}$, $V_{RB}$, $V_{eff}$ may be constant in time or varying in time. That is, exposures may be done with a constant velocity $V_{OB}$, $V_{RB}$, $V_{eff}$. In addition, exposures may be done with a non-constant (or variable) velocity $V_{OB}$, $V_{RB}$, $V_{eff}$. The actual velocity (or velocity profile) may be governed by the requested or desired wafer throughput.

In an embodiment, the object OB may comprise a patterning device, which may be for example a mask (e.g., as shown in Figure 1) comprising a circuit pattern to be transferred onto a target portion C on a substrate W.

In an embodiment, the collected part of the radiation beam RB' coming from the object OB may comprise a portion of the radiation beam RB' having transmitted through the object OB. In the case of the object OB being a patterning device, such a transmitted radiation beam RB' may carry a pattern imparted by the patterning device which may be transferred by a projection lens assembly onto a target portion of a substrate (as described above in relation to Figure 1).

In an embodiment, the optical scanning assembly OSA may be configured to direct the input radiation beam RB towards the object OB at a normal incidence angle. This may be a preferred configuration when the optical arrangement 300 is used in a lithographic apparatus, in particular a lithographic apparatus of transmissive type, because illuminating the object OB (e.g., a transmissive mask) at a normal incidence angle can reduce optical distortion in the pattern imparted to the transmitted portion of the radiation beam RB' by the object OB.

In an embodiment, the object table assembly OTA may comprise an object support for holding the object OB and at least one positioner (not shown) for positioning the object support. Each of the at least one positioner may comprise one or more actuators for actuating the object support.

In an embodiment, the at least one positioner may be configured to move the object support in a first direction along a first axis (e.g., X-axis) and in a second direction along a second axis (e.g., Y-axis) orthogonal to the first axis, said first direction and said second direction both in the plane of the object PO.

The optical scanning assembly OSA may be a stage system comprising a plurality optical elements. At least a portion of the plurality of optical elements are operable to move. The stage system may comprise a plurality of actuators that are arranged to actuate and to move (scan) at least a portion of the plurality of optical elements.

In the following paragraphs, specific configurations of the optical arrangement 300 will be described in the context of a lithographic apparatus. However, it will be appreciated that the optical arrangement 300 may also be configured in different configurations for use in other apparatuses.

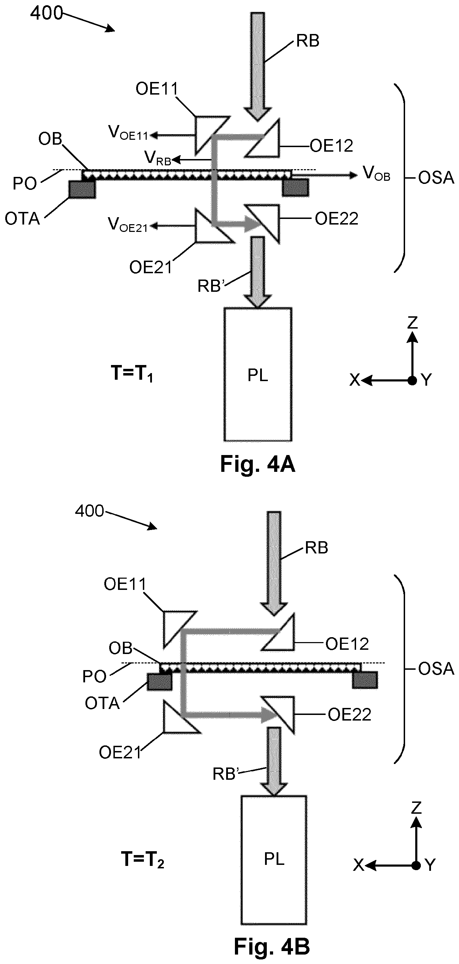

Figures 4A-4C depict schematically an embodiment of an optical arrangement 400 configured for use in a lithographic apparatus of transmissive type (e.g., a DUV scanner) at three different time instances $T_1$, $T_2$, and $T_3$. The time instances $T_1$, $T_2$, and $T_3$ may correspond respectively to a time during a scan-up exposure, at an end of the scan-up exposure, and a time during a scan-down exposure.

With reference to Figures 4A-4C, in an embodiment, the optical scanning assembly OSA may comprise at least a first pair of optical elements OE11, OE12 configured to receive the input radiation beam RB and direct the radiation beam RB towards the object OB for illumination, wherein at least a first optical element OE11 of the first pair of optical elements OE11, OE12 may be operable to move relative to a second optical element OE12 of the first pair of optical elements OE11, OE12 so as to move the radiation beam RB. In an embodiment, the first optical element OE11 of the first pair of optical elements OE11, OE12 may be operable to move and the second optical element OE12 of the first pair of optical elements OE11, OE12 may be fixed.

With continued reference to Figures 4A-4C, the optical scanning assembly OSA may further comprise at least a second pair of optical elements OE21, OE22 configured to collect the at least part of the radiation beam RB' coming from the object OB (in this case, a portion of the radiation beam RB' having transmitted through the object OB), and direct the at least part of the radiation beam RB' coming from the object OB, wherein at least a first optical element OE21 of the second pair of optical elements OE21, OE22 may be operable to move relative to a second optical element OE22 of the second pair of optical elements OE21, OE22. In an embodiment, the first optical element OE21 of the second pair of optical elements OE21, OE22 may be operable to move and the second optical element OE22 of said second pair of optical elements OE21, OE22 is fixed.

In an embodiment, the second pair of optical elements OE21, OE22 may be configured to direct the at least part of the radiation beam RB' coming from the object OB along a fixed optical path. When used in a lithographic apparatus, the collected part of the radiation beam RB' coming from the object OB (e.g., the transmitted radiation beam RB') may be directed by the second pair of optical elements OE21, OE22 to a projection lens assembly PL (e.g., projection system PS depicted in Figure 1), which may be configured to project the collected radiation beam RB' onto a target portion of a substrate. Any small deviation (e.g., pointing and lateral shift) from an optimal optical path of the collected radiation beam RB' can result in a significant amount of misalignment in the downstream optics (e.g., in the projection lens assembly PL) and consequently cause imaging errors. Therefore, it is advantageous that the collected part of the radiation beam RB' coming from the object OB is directed along a fixed optical path upon leaving the optical scanning assembly OSA.

In an embodiment, the optical scanning assembly OSA may comprise additional optical elements (e.g., one or more lenses, and/or one or more mirrors). Such additional optical elements may be placed between the two optical elements of the first pair of optical elements OE11, OE12 and/or second pair of optical elements OE21, OE22 and may be used for radiation beam controlling (e.g., beam shaping, beam steering, etc.). In an embodiment, additional optical elements may be arranged to ensure that the radiation beam RB impinging the object OB and the collected part of the radiation beam RB' are substantially unaffected by the scanning actions.

With continued reference to Figures 4A-4C, the first pair of optical elements OE11, OE12 may be located on a first side of the plane of the object PO and the second pair of optical elements OE21, OE22 may be located on a second side of the plane of the object PO. The first optical element OE11 of the first pair of optical elements OE11, OE12 and the first optical element OE21 of the second pair of optical elements OE21, OE22 may be configured to move simultaneously to vary a distance between the first optical element OE11, OE21 of each of the first pair of optical elements OE11, OE12 and the second pair of optical elements OE21, OE22 with respect to the second optical element OE12, OE22 of each of the first pair of optical elements OE11, OE12 and the second pair of optical elements OE21, OE22.

In an embodiment, each of the first optical element OE11, OE21 and the second optical element OE12, OE22 of one or both of the first pair of optical elements OE11, OE12 and/or the second pair of optical elements OE21, OE22 may comprise parallel reflective surfaces. For example, as shown in Figures 4A-4C, the first pair of the optical elements OE11, OE12 may comprise a first moving reflector OE11 and a first fixed reflector OE12. The first moving reflector OE11 may be moveable in a plane substantially parallel to that of the object OB with respect to the first fixed reflector OE12. The first fixed reflector OE12 may be configured to receive the input radiation beam RB and then reflect it to the first moving reflector OE11, which may be configured to reflect the input radiation beam RB towards the object OB. The input radiation beam RB may be normally incident onto the object OB. The movement of the first moving reflector OE11 may result in the movement of the input radiation beam RB with respect to the object OB. The second pair of the optical elements OE21, OE22 may comprise a second moving reflector OE21 and a second fixed reflector OE22. The second moving reflector OE21 may be moveable in a plane substantially parallel to that of the object OB with respect to the second fixed reflector OE22. The second moving reflector OE21 may be configured to collect a portion of the radiation beam RB' having transmitted from the object OB and reflect it to the second fixed reflector OE22. The second fixed reflector OE22 may be configured to reflect the portion of the transmitted radiation beam RB' into a fixed optical path. In a preferred embodiment, the first moving reflector OE11 and the second moving reflector OE21 may be operable to move concurrently at a same velocity, i.e., in a same direction and at a same speed. This may ensure that the portion of the transmitted radiation beam RB' follows a fixed optical path when directed to the projection lens assembly PL.

The first moving reflector OE11 and the second moving reflector OE21 may each be operable to move from a start position to an end position. Movement of each of the first moving reflector OE11 and the second moving reflector OE21 may be enabled by at least one actuator. In some cases, the end position may be an absolute end position where the at least one actuator reaches its end of travel. In other cases, the end position may be an intermediate position where the at least one actuator is still within its travel range. Such an intermediate position may be predefined. The distance between the start position and the end position may be sufficiently large such that the input radiation beam RB can scan across the full width of a target area (e.g., the area comprising a circuit pattern) of the object OB (e.g., mask). In an embodiment, the optical scanning assembly OSA may comprise a controller configured to control the at least one actuator enabling the movement of the moving reflectors OE11, OE21, the object OB, and/or the substrate support (e.g., WTa in Figure 1).

Figure 4A depicts schematically the optical arrangement 400 at a first time instance T=Ti during a scan-up exposure. The first fixed reflector OE12 may be fixed in a position near one edge of the object OB, when the object OB is at its starting position. The first moving reflector OE11 may stay in a default position before any exposure starts. The default position of the first moving reflector OE11 may be a position sufficiently close to the position of the first fixed reflector OE12 such that the input radiation beam RB stays outside a target area before any exposure starts. The second fixed reflector OE22 and the second moving reflector OE21 may be placed on the other side of the object OB (or the plane of the object PO) and may be arranged in a similar manner as the first fixed reflector OE12 and the first moving reflector OE11, respectively.

With continued reference to Figure 4A, during the scan-up exposure, the first moving reflector OE11 and the second moving reflector OE21 may be operable to move concurrently and at a same velocity ($V_{OE11} = V_{OE21}$) from their respective start positions (e.g., default positions) to their respective end positions (e.g., predefined intermediate positions). The first and second moving reflectors OE11 and OE21 may move in a first direction (right to left) along the X-axis, resulting in the input radiation beam RB scanning across an area of the object OB in the first direction. The scanning velocity $V_{RB}$ of the input radiation beam may be same as that of the first moving reflector OE11 (and optionally the second moving reflector OE21) ($V_{RB} = V_{OE11}$). At the same time, the object table assembly OTA may be operable to move the object OB at a velocity $V_{OB}$ also along the X-axis, but in a second direction (left to right) opposite to the first direction.

In a different embodiment, the first moving reflector OE11 and the second moving reflector OE21 may be operable to move at different velocities, i.e., $V_{OE11} \neq V_{OE21}$.

Figure 4B depicts schematically the optical arrangement 400 at a second time instance T=Ti at the end of the scan-up exposure. At this moment of time, the first moving reflector OE11 and the second moving reflector OE21 may both have stopped at their respective end positions and are waiting for commands to carry out a next exposure (or a scan down exposure).

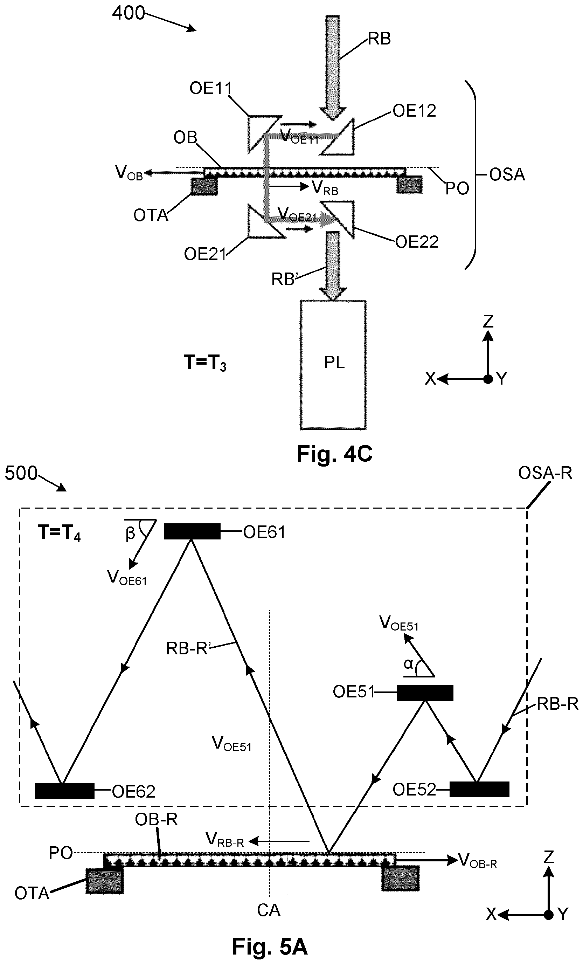

Figure 4C depicts schematically the optical arrangement 400 at a third time instance T=Ts during a scan-down exposure. During the scan-down exposure, the first moving reflector OE11 and the second moving reflector OE21 may be operable to move concurrently and at a same velocity ($V_{OE11} = V_{OE21}$) from their respective end positions back to their respective start positions. The first and second moving reflectors OE11 and OE21 may move in the second direction (left to right) along the X-axis, resulting in the input radiation beam RB scanning across an area of the object OB in the second direction. The scanning velocity $V_{RB}$ of the input radiation beam may be same as that of the first moving reflector OE11 (and optionally the second moving reflector OE21) ($V_{RB} = V_{OE11}$). At the same time, the object table assembly OTA may be operable to move at a velocity $V_{OB}$ also along the X-axis but in the first direction (right to left).

In a different embodiment, the first moving reflector OE11 and the second moving reflector OE21 may be operable to move at different velocities, i.e., $V_{OE11} \neq V_{OE21}$.

During either the scan-up exposure or scan-down exposure, the part of the transmitted radiation beam RB' collected by the second pair of optical elements OE21, OE22 may be directed along a fixed optical path in downstream optics, e.g., in a projection lens assembly PL. Additional optical elements (e.g., one or more lenses, and/or one or more mirrors) may be arranged to direct the transmitted radiation beam RB'.

It will be appreciated that the concept of increasing the effective velocity of the object relative to the input radiation beam by simultaneously moving the input radiation beam and the object in anti-parallel or opposite directions is equally applicable for a lithographic apparatus of reflective type (e.g., a EUV lithographic apparatus). In such a case, the object may be configured to be reflective of the input radiation beam rather than being transmissive of the input radiation beam as shown in Figures 3, and 4A-4C.

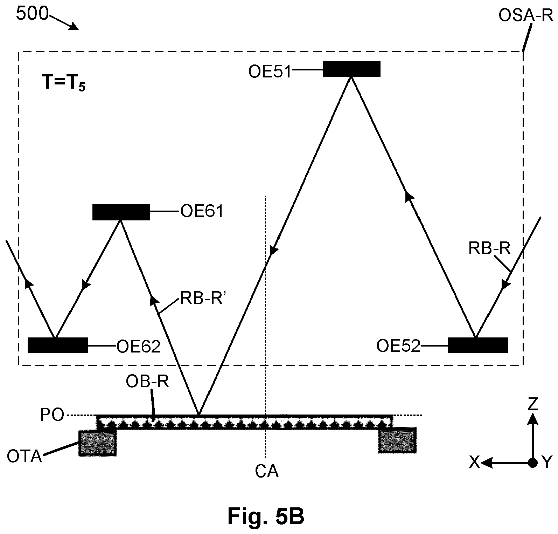

Figures 5A and 5B depict schematically a different embodiment of an optical arrangement 500 configured for use in a lithographic apparatus of reflective type (e.g., a EUV scanner) at two different time instances $T_4$ and $T_5$. For the sake of simplicity, same reference signs are used for elements similar to or same as those shown in Figures 3 or 4A-4C and description of such elements will not be repeated in the following paragraphs. In this embodiment, the object OB-R may comprise a reflective mask for use in, e.g., a EUV exposure apparatus. The first pair of optical elements OE51, OE52 and the second pair of optical elements OE61, OE62 may be located on a same side of the object OB-R or the plane of the object PO. The first pair of optical elements OE51, OE52 may be located on a first side of a center axis of the object CA and the second pair of optical elements OE61, OE62 may be located on a second side of the center axis of the object CA. The first pair of optical elements OE51, OE52 may be configured to receive the input radiation beam RB-R and direct the radiation beam RB-R towards the object OB-R for illumination. The second pair of optical elements OE61, OE62 may be configured to collect the at least part of the radiation beam RB-R' coming from the object OB-R (in this case, a portion of the radiation beam RB-R' having reflected from the object OB-R), and direct the at least part of the radiation beam RB-R', coming from the object OB-R, e.g., along a fixed optical path.

Figure 5A depicts schematically the optical arrangement 500 at a fourth time instance $T=T_4$ during a scan-up exposure. During the scan-up exposure, the first moving reflector OE51 and the second moving reflector OE61 may be operable to move concurrently and at respective velocities $V_{OE51}$ and $V_{OE61}$. The velocity $V_{OE51}$ of the first moving reflector OE51 and the velocity $V_{OE61}$ of the second moving reflector OE61 may have a same amplitude or speed, but different directions (see arrows in Figure 5A). Similar to the example scenario shown in Figure 4A, the first moving reflector OE51 and the second moving reflector OE61 may move from their respective start positions (e.g., default positions) to their respective end positions (e.g., predefined intermediate positions). The movement of the first moving reflector OE51 may result in the input radiation beam RB-R scanning across an area of the object OB-R in a first direction (right to left). At the same time, the object table assembly OTA may be operable to move at a velocity $V_{OB-R}$ also along the X-axis, but in a second direction (left to right) opposite to the first direction. The scanning velocity $V_{RB-R}$ of the input radiation beam RB-R and the velocity of the first moving reflector OE51 may fulfill the following relation:

$$|V_{RB-R}| = |V_{OE51}| \cdot \cos(\alpha), \qquad\qquad [4]$$

where $\alpha$ denotes the angle between the direction of the velocity $V_{OE51}$ of the first moving reflector OE51 and the X-axis.

To ensure the reflected radiation beam RB-R' follows a fixed optical path after leaving the optical scanning assembly OSA-R, the velocity $V_{OE61}$ of the second moving reflector OE61 and the scanning velocity $V_{RB-R}$ of the input radiation beam RB-R may fulfill the following relation:

$$|V_{RB-R}| = |V_{OE61}| \cdot \cos(\beta), \qquad\qquad [5]$$

where /3 denotes the angle between the direction of the velocity $V_{OE61}$ of the second moving reflector and the X-axis. In some cases, the two angles $\alpha$ and $\beta$ may be different while in other cases they may be equal to each other.

The optical scanning assembly OSA-R may comprise additional optical elements (e.g., one or more reflective elements). Such additional optical elements may be placed between the two optical elements of the first pair of optical elements OE51, OE52 and/or second pair of optical elements OE61, OE62 and may be used for beam controlling (e.g., beam shaping, beam steering, etc.). In an embodiment, additional optical elements may be arranged to ensure that the input radiation beam RB-R impinging the object OB-R and the collected part of the reflected radiation beam RB-R' are substantially unaffected by the scanning actions.

Figure 5B depicts schematically the optical arrangement 500 at a fifth time instance T=Ts at the end of the scan-up exposure. At this moment of time, the first moving reflector OE51 and the second moving reflector OE61 may both have stopped at their respective end positions (e.g., predefined intermediate positions) and are waiting for commands to carry out a next exposure (or a scan-down exposure), similar to the scenario shown in Figure 4B.

In a scan-down exposure (not shown), the first moving reflector OE51 and the second moving reflector OE61 may be configured to move back to their respective start positions, resulting in the input radiation beam RB-R scanning across an area of the object OB-R in the second direction (left to right). At the same time, the object table assembly OTA may be operable to move at a velocity $V_{OB-R}$ also along the X-axis but in the first direction (right to left).

According to an aspect of the present disclosure, there is provided a method of improving throughput of a lithographic apparatus, comprising: illuminating a patterning device OB, OB-R by a radiation beam RB, RB-R; moving the radiation beam RB, RB-R with respect to the patterning device OB, OB-R in a first direction; and moving the patterning device OB, OB-R in a plane of the patterning device PO in a second direction opposite to the first direction while the patterning device is being illuminated by the radiation beam RB, RB-R; wherein the patterning device OB, OB-R and the radiation beam RB, RB-R are moved concurrently while the patterning device OB, OB-R is being illuminated by the radiation beam RB, RB-R; exposing at least one target portion on the substrate (e.g., as shown in Figure 1) using at least part of the radiation beam coming from the patterning device RB', RB-R'.

According to an aspect of the present invention, there is provided a stage system suitable to be arranged and used in an exposure apparatus comprising: a first optical element OE11 configured to be arranged at a first side of an object plane PO, in which an object OB to be illuminated can be arranged, and to guide an illumination beam RB to the object plane PO, a second optical element OE21 configured to be arranged at a second side of the object plane PO, and to guide the illumination beam RB' after passing the object plane PO, and wherein the first and second optical element OE11, OE21 are configured to move (simultaneously) in an opposite direction being opposite to a direction of a movement of the object OB during an illumination period of the object OB.

Each of the first optical element OE11, the second optical element OE21, and the object OB may be actuated and moved by means of an actuator. The first and second optical element OE11, OE21 may be actuated and moved by one and the same actuator.

The movement, direction, and velocity of the first optical element OE11, the second optical element OE21, and the object OB may be controlled by a controller. The controller may be an external control unit or a control unit arranged in the exposure apparatus.

The concepts herein are equally applicable to a single stage lithographic apparatus or scanner used in combination with a stand-alone alignment tool or alignment station, where the alignment station is the measurement side and the scanner is the exposure side. As such, a lithographic apparatus arrangement may comprise a dual stage lithographic apparatus or single stage lithographic apparatus with stand-alone alignment station.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals ( e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Aspects of the invention are set out in the clauses below.

1. An optical arrangement for use in an exposure apparatus, comprising:

an object table assembly configured to hold and move an object in a plane of the object; and

an optical scanning assembly configured to receive a radiation beam, direct the radiation beam towards the object so as to illuminate at least an area of the object in the plane of the object, and

subsequently collect at least part of the radiation beam coming from the object;

wherein the object table assembly and at least a part the optical scanning assembly are operable to move concurrently while the object is being illuminated by the radiation beam such that the optical scanning assembly moves the radiation beam in a direction substantially anti-parallel to a direction of movement of the object table assembly thereby scanning the radiation beam over at least a portion of said object.

2. An optical arrangement according to clause 1, wherein the at least part of the radiation beam coming from the object comprises a portion of the radiation beam having transmitted through the object.

3. An optical arrangement according to clause 2, wherein the optical scanning assembly is configured to direct the radiation beam towards the object at a normal incidence angle.

4. An optical arrangement according to clause 1, wherein the at least part of the radiation beam coming from the object comprises a portion of the radiation beam having reflected from the object.

5. An optical arrangement according to any preceding clause, wherein the object table assembly comprises an object support for holding the object and at least one positioner for positioning the object support.

6. An optical arrangement according to clause 5, wherein the at least one positioner is configured to move the object support along a first axis and a second axis orthogonal to the first axis, said first axis and said second axis both in the plane of the object.

7. An optical arrangement according to any preceding clause, wherein the optical scanning assembly comprises at least a first pair of optical elements configured to receive the radiation beam and direct the radiation beam towards the object for illumination, wherein at least a first optical element of said first pair of optical elements is operable to move relative to a second optical element of said first pair of optical elements so as to move said radiation beam.

8. An optical arrangement according to clause 7, wherein the first optical element of said first pair of optical elements is operable to move and said second optical element of said first pair of optical elements is fixed.

9. An optical arrangement according to clause 7 or 8, comprising at least a second pair of optical elements configured to collect the at least part of the radiation beam coming from the object, and direct the at least part of the radiation beam coming from the object, wherein at least a first optical element of said second pair of optical elements is operable to move relative to a second optical element of said second pair of optical elements.

10. An optical arrangement according to clause 9, wherein the first optical element of said second pair of optical elements is operable to move and said second optical element of said second pair of optical elements is fixed.

11. An optical arrangement according to clause 9 or 10, wherein the second pair of optical elements is configured to direct the at least part of the radiation beam coming from the object along a fixed optical path.

12. An optical arrangement according to any of clauses 9 to 11, wherein said first pair of optical elements is located on a first side of the plane of the object and said second pair of optical elements is located on a second side of the plane of the object, or said first pair of optical elements is located on a first side of a center axis of the object and said second pair of optical elements is located on a second side of the center axis of the object.

13. An optical arrangement according to any of clauses 9 to 12, wherein said first optical element of said first pair of optical elements and said first optical element of said second pair of optical elements are configured to move simultaneously to vary a distance between said first optical element of each of said first pair of optical elements and said second pair of optical elements with respect to said second optical element of each of said first pair of optical elements and said second pair of optical elements.

14. An optical arrangement according to any of clauses 7 to 13, wherein said first optical element and/or said second optical element of said first pair of optical elements and/or said second pair of optical elements comprise a reflector.

15. An optical arrangement according to clause 14, wherein each of said first optical element and said second optical element of one or both of said first pair of optical elements and/or said second pair of optical elements comprise parallel reflective surfaces.

16. An optical arrangement according to any preceding clause, wherein the object comprises a patterning device.

17. An optical arrangement according to clause 16, wherein the patterning device is a mask comprising a circuit pattern to be transferred onto a target portion on a substrate.

18. A lithographic apparatus comprising an optical arrangement according to any preceding clause.

19. A lithographic apparatus according to clause 18, further comprising:

at least one substrate support for supporting a substrate; and

a projection lens assembly configured to receive and guide the at least part of the radiation beam collected by the optical scanning assembly to the substrate so as to expose at least one target portion on the substrate.

20. A method of exposing a circuit pattern on at least one target portion on a substrate, comprising:

illuminating a patterning device by a radiation beam;

moving the patterning device in a first direction in a plane of the patterning device while the patterning device is being illuminated by the radiation beam; and

moving the radiation beam with respect to the patterning device in a second direction opposite to the first direction; wherein the patterning device and the radiation beam are moved concurrently while the patterning device is being illuminated by the radiation beam;

exposing the circuit pattern on the at least one target portion on the substrate using at least part of the radiation beam coming from the patterning device.

21. A method according to clause 20, wherein the at least part of the radiation beam coming from the patterning device comprises a portion of the radiation beam having transmitted through the patterning device.

22. A method according to clause 21, wherein the patterning device is illuminated at a normal incidence angle.

23. A method according to clause 20, wherein the at least part of the radiation beam coming from the patterning device comprises a portion of the radiation beam having reflected from the patterning device.

24. A method according to any of clauses 20 to 23, wherein the at least part of the radiation beam coming from the patterning device is directed along a fixed optical path.

25. A computer program comprising program instructions operable to perform the method of any of clauses 20 to 24, when run on a suitable apparatus.

26. A non-transient computer program carrier comprising the computer program of clause 25.

27. A processing system comprising a processor and a storage device comprising the computer program of clause 26.

28. An optical arrangement according to clause 10, further comprising at least a first actuator configured to move the first optical element of said first pair of optical elements and the first optical element of said second pair of optical elements and a second actuator configured to move the object table assembly.

29. A stage system for an exposure apparatus comprising:

a first optical element configured to be arranged at a first side of an object plane, in which an object to be illuminated can be arranged, and to guide an illumination beam to the object plane;

a second optical element configured to be arranged at a second side of the object plane, and to guide the illumination beam after passing the object plane; and

wherein the first and second optical element are configured to move simultaneously in an opposite direction being opposite to a direction of a movement of the object during an illumination period of the object.

30. A stage system according to clause 29, wherein a plurality of actuators are arranged to actuate and to move the first optical element, the second optical element, and the object.

The breadth and scope of the present invention should not be limited by any of the above-described exemplary embodiments, but should be defined only in accordance with the following claims and their equivalents.

**Claims**

1.  An optical arrangement for use in an exposure apparatus, comprising:

an object table assembly configured to hold and move an object in a plane of the object; and

an optical scanning assembly configured to receive a radiation beam, direct the radiation beam towards the object so as to illuminate at least an area of the object in the plane of the object, and subsequently collect at least part of the radiation beam coming from the object;

wherein the object table assembly and at least a part of the optical scanning assembly are operable to move concurrently while the object is being illuminated by the radiation beam such that the optical scanning assembly moves the radiation beam in a direction substantially anti-parallel to a direction of movement of the object table assembly thereby scanning the radiation beam over at least a portion of said object.

2.  An optical arrangement as claimed in claim 1, wherein the at least part of the radiation beam coming from the object comprises a portion of the radiation beam having transmitted through the object.

3.  An optical arrangement as claimed in claim 2, wherein the optical scanning assembly is configured to direct the radiation beam towards the object at a normal incidence angle.

4. An optical arrangement as claimed in claim 1, wherein the at least part of the radiation beam coming from the object comprises a portion of the radiation beam having reflected from the object.

5. An optical arrangement as claimed in any preceding claim, wherein the object table assembly comprises an object support for holding the object and at least one positioner for positioning the object support.

6. An optical arrangement as claimed in claim 5, wherein the at least one positioner is configured to move the object support along a first axis and a second axis orthogonal to the first axis, said first axis and said second axis both in the plane of the object.

7. An optical arrangement as claimed in any preceding claim, wherein the optical scanning assembly comprises at least a first pair of optical elements configured to receive the radiation beam and direct the radiation beam towards the object for illumination, wherein at least a first optical element of said first pair of optical elements is operable to move relative to a second optical element of said first pair of optical elements so as to move said radiation beam.

8. An optical arrangement as claimed in claim 7, wherein the first optical element of said first pair of optical elements is operable to move and said second optical element of said first pair of optical elements is fixed.

9. An optical arrangement as claimed in claim 7 or 8, comprising at least a second pair of optical elements configured to collect the at least part of the radiation beam coming from the object, and direct the at least part of the radiation beam coming from the object, wherein at least a first optical element of said second pair of optical elements is operable to move relative to a second optical element of said second pair of optical elements.

10. An optical arrangement as claimed in claim 9, wherein the first optical element of said second pair of optical elements is operable to move and said second optical element of said second pair of optical elements is fixed.

11. An optical arrangement according to claim 10, further comprising at least a first actuator configured to move the first optical element of said first pair of optical elements and the first optical element of said second pair of optical elements and a second actuator configured to move the object table assembly.

12. A lithographic apparatus comprising an optical arrangement as claimed in any preceding claim.

13. A lithographic apparatus as claimed in claim 12, further comprising:

at least one substrate support for supporting a substrate; and
a projection lens assembly configured to receive and guide the at least part of the radiation beam collected by the optical scanning assembly to the substrate so as to expose at least one target portion on the substrate.

14. A method of exposing a circuit pattern on at least one target portion on a substrate, comprising:

illuminating a patterning device by a radiation beam;
moving the patterning device in a first direction in a plane of the patterning device while the patterning device is being illuminated by the radiation beam; and
moving the radiation beam with respect to the patterning device in a second direction opposite to the first direction;
wherein the patterning device and the radiation beam are moved concurrently while the patterning device is being illuminated by the radiation beam;
exposing the circuit pattern on the at least one target portion on the substrate using at least part of the radiation beam coming from the patterning device.

15. A method as claimed in claim 14, wherein the at least part of the radiation beam coming from the patterning device comprises a portion of the radiation beam having transmitted through the patterning device or having reflected from the patterning device.

**Fig. 1**

**Fig. 2**

**Fig. 3**

**Fig. 4A**

**Fig. 4B**

**Fig. 4C**

**Fig. 5A**

Fig. 5B

Europäisches
Patentamt

European
Patent Office

Office européen
des brevets

# EUROPEAN SEARCH REPORT

Application Number

**EP 23 18 6771**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 604 779 A (AMEMIYA MITSUAKI [JP] ET AL) 18 February 1997 (1997-02-18) | 1-3,5,6, 12-15 | INV. G03F7/20 |
| Y | * column 2, line 64 – column 3, line 34 * | 7-9 | |
| A | * column 4, line 60 – column 6, line 12 * * column 9, lines 13-57 * * figures 1, 3-4, 8-9 * | 10,11 | |
| Y | US 6 078 641 A (MITSUI SOICHIRO [JP] ET AL) 20 June 2000 (2000-06-20) * column 31, lines 6-22 * * figure 20A * | 7,8 | |
| Y | EP 3 550 365 A1 (SHANGHAI MICRO ELECTRONICS EQUIPMENT GROUP CO LTD [CN]) 9 October 2019 (2019-10-09) * paragraph [0030] – paragraph [0031] * * figure 6 * | 7,8 | |
| Y | WO 2014/064224 A1 (ZEISS CARL SMT GMBH [DE]) 1 May 2014 (2014-05-01) * page 18, lines 8-36 * * figure 10 * | 7,9 | |

TECHNICAL FIELDS SEARCHED (IPC)

G03F

The present search report has been drawn up for all claims

| Place of search | Date of completion of the search | Examiner |
|---|---|---|
| Munich | 5 February 2024 | Maslankiewicz, Pawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

EP 23 18 6771

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

    see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

    1-3, 5-14(completely); 15(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

**EP 23 18 6771**

The Search Division considers that the present European patent application does not comply with the requirements of unity of invention and relates to several inventions or groups of inventions, namely:

1. claims: 1-3, 5-14(completely); 15(partially)

   Optical arrangement and method of exposing a circuit pattern,
   wherein the at least part of the radiation beam coming from the object or the patterning device comprises a portion of the radiation beam having transmitted through the object or the patterning device
   ---

2. claims: 4(completely); 15(partially)

   Optical arrangement and method of exposing a circuit pattern,
   wherein the at least part of the radiation beam coming from the object or the patterning device comprises a portion of the radiation beam having reflected from the object or the patterning device
   ---

## ANNEX TO THE EUROPEAN SEARCH REPORT
## ON EUROPEAN PATENT APPLICATION NO.

**EP 23 18 6771**

This annex lists the patent family members relating to the patent documents cited in the above-mentioned European search report.
The members are as contained in the European Patent Office EDP file on
The European Patent Office is in no way liable for these particulars which are merely given for the purpose of information.

**05-02-2024**

| Patent document cited in search report | | Publication date | Patent family member(s) | | Publication date |
|---|---|---|---|---|---|
| US 5604779 | A | 18-02-1997 | JP | 3287725 B2 | 04-06-2002 |
| | | | JP | H0855785 A | 27-02-1996 |
| | | | US | 5604779 A | 18-02-1997 |
| US 6078641 | A | 20-06-2000 | JP | 3532742 B2 | 31-05-2004 |
| | | | JP | H1174181 A | 16-03-1999 |
| | | | US | 6078641 A | 20-06-2000 |
| EP 3550365 | A1 | 09-10-2019 | CN | 108121179 A | 05-06-2018 |
| | | | EP | 3550365 A1 | 09-10-2019 |
| | | | JP | 6810801 B2 | 06-01-2021 |
| | | | JP | 2020501135 A | 16-01-2020 |
| | | | KR | 20190084109 A | 15-07-2019 |
| | | | TW | 201821860 A | 16-06-2018 |
| | | | US | 2019390957 A1 | 26-12-2019 |
| | | | WO | 2018099348 A1 | 07-06-2018 |
| WO 2014064224 | A1 | 01-05-2014 | DE | 102012219545 A1 | 30-04-2014 |
| | | | WO | 2014064224 A1 | 01-05-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6788391 B2
- US 7016013 B2